# EUROPÄISCHE PATENTSCHRIFT

(11) **EP 3 667 761 B1**
(45) Veröffentlichungstag und Bekanntmachung des Hinweises auf die Patenterteilung: **17.02.2021**
(21) Anmeldenummer: 18212315.8
(22) Anmeldetag: 13.12.2018
(51) Int. Cl.: H01M 2/10, H01M 2/20, H05K 3/34, H01M 2/02

(54) **ZYLINDRISCHE ZELLE MIT KONTAKTFAHNEN**
CYLINDRICAL CELL WITH CONTACT TABS
CELLULE CYLINDRIQUE À LANGUETTES DE CONTACT

(43) Veröffentlichungstag der Anmeldung: 17.06.2020
(73) Patentinhaber: VARTA Microbattery GmbH, 73479 Ellwangen Jagst (DE)
(72) Erfinder: Nestle, Marc Oliver, 597719 Singapore (SG); Siddannavar, Sunil, 587119 Karanataka (IN)
(74) Vertreter: Patentanwaltskanzlei Cartagena

(56) Entgegenhaltungen:
- EP-A1- 0 981 173
- DE-A1-102013 001 371
- US-A1- 2008 089 011
- US-A1- 2011 001 618

## Beschreibung

Die nachfolgend beschriebene Erfindung betrifft eine zylindrische Zelle mit Kontaktfahnen.

Solche Kontaktfahnen werden benötigt, um Zellen in elektronischen Geräten, beispielsweise auf Platinen, zu fixieren, insbesondere durch Verlötung oder Verschweißung. Die Kontaktfahnen diesen zum einen als mechanisches Befestigungsmittel, zum anderen aber auch als elektrische Leiter. Zu diesem Zweck weisen die Zellen in der Regel stets eine mit ihrem positiven und eine mit ihrem negativen Pol verbundene Kontaktfahne auf. Zellen mit solchen Kontaktfahnen sind beispielsweise aus der US 2011/001618 A1 bekannt.

Häufig handelt es sich bei den Zellen um Knopfzellen, so auch bei den in der US 2011/001618 A1 dargestellten Zellen. Definitionsgemäß sind Knopfzellen Zellen mit rundem, meist zylindrischem Querschnitt, deren Höhe kleiner ist als ihr Durchmesser. Axial werden Knopfzellen in aller Regel durch zwei ebene, meist kreisrunde Stirnseiten begrenzt. Aus produktionstechnischen Gründen erfolgt in diesen Bereichen meist auch die Anbringung der Kontaktfahnen. Bei den Kontaktfahnen handelt es sich meist um flache Blechstreifen, die, beispielsweise durch Widerstandsschweißen, auf die Stirnseiten aufgebracht werden. Durch ein Umbiegen einer der Kontaktfahnen um 90° kann diese Kontaktfahne auf die Seite der gegenüberliegenden Stirnseite geführt werden. Wenn sich die Kontaktfahnen in der gleichen Ebene befinden, ist ihre Fixierung auf einer Platine besonders einfach.

In den letzten Jahren wurden verstärkt auch Knopfzellen entwickelt, die auf Lithium-Ionen-Technologie basieren, siehe beispielsweise WO 2010/089152 A1. Solche Knopfzellen benötigen verstärkt Sicherheitslösungen, da sie aufgrund ihrer hohen Energiedichte sowie ihrer leicht brennbaren Bestandteile im Schadensfall eine große Gefahr für Verbraucher darstellen können.

Eine bekannte Sicherheitslösung für Knopfzellen besteht darin, in eine ihrer Stirnseiten ein Berstkreuz einzubringen. Bildet sich innerhalb einer Zelle ein Überdruck und überschreitet dieser einen Druckschwellenwert, so öffnet sich das Gehäuse der Knopfzelle im Bereich des Berstkreuzes auf kontrollierte Weise und der Überdruck kann entweichen.

Ein solches Berstkreuz kann beim Aufschweißen einer Kontaktfahne auf eine mit einem Berstkreuz versehenen Stirnseite allerdings leicht blockiert werden. Auch der Berstvorgang selbst kann behindert werden, nämlich wenn die Stirnseite mit dem Berstkreuz zu nahe an der Oberfläche der Platine zu liegen kommt. Es musste daher entweder ein Mindestabstand zwischen dieser Stirnseite der Knopfzelle und der Platine eingehalten werden, was zu Lasten der Kompaktheit ging, oder aber die Stirnseite mit dem Berstkreuz musste weg von der Platine weisen.

Eine deutlich anspruchsvollere Sicherheitslösung ist aus der WO 2012/048995 A1 bekannt. Gemäß dieser ist das Gehäuse eine Knopfzelle als Ganzes ventilartig ausgebildet. Es besteht aus zwei axial gegeneinander verschiebbaren Gehäuseteilen, die bei einem Überdruck in definiertem Umfang auseinandergleiten können. Hierbei wird eine Durchbrechung im Gehäusemantel freigelegt, über welche der Überdruck kontrolliert abgebaut werden kann.

Bei mittels der beschriebenen Kontaktfahnen auf einer Platine fixierten Knopfzellen musste allerdings auch bei dieser Sicherheitslösung ein Mindestabstand zwischen einer Stirnseite der Knopfzelle und der Platine eingehalten werden. Mit der Platine verschweißte oder verlötete Kontaktfahnen könnten ansonsten einem Auseinandergleiten von Gehäuseteilen einer Zelle gemäß der WO 2012/048995 A1 einen mechanischen Widerstand entgegensetzen, dieses gegebenenfalls sogar blockieren. Entsprechende technische Lösungen gingen entsprechend ebenfalls zu Lasten der Kompaktheit.

Der beschriebenen Erfindung lag die Aufgabe zugrunde, eine Lösung für diese Probleme bereitzustellen.

Zur Lösung dieser Aufgabe schlägt die Erfindung die nachfolgend beschriebene Zelle mit den Merkmalen des Anspruchs 1 vor. Weiterbildungen der Erfindung sind Gegenstand von Unteransprüchen.

Die erfindungsgemäße Zelle ist zylindrisch ausgebildet und weist in der Regel stets die folgenden sechs Merkmale a. bis f. auf:
a. Die Zelle umfasst ein einen Innenraum einschließendes, aus einem ersten und einem zweiten metallischen Gehäuseteil zusammengesetztes, zylindrisches Gehäuse,
b. das Gehäuse umfasst an seinen axialen Enden eine erste ebene Stirnseite und eine zweite ebene Stirnseite, die über einen ringförmigen Mantel miteinander verbunden sind,
c. die Zelle umfasst eine positive Elektrode und eine negative Elektrode, von denen mindestens eine Lithiumionen interkalieren und/oder deinterkalieren kann,
d. die positive Elektrode ist unmittelbar oder über einen separaten elektrischen Leiter elektrisch mit dem ersten Gehäuseteil und die negative Elektrode ist unmittelbar oder über einen separaten elektrischen Leiter elektrisch mit dem zweiten Gehäuseteil verbunden,
e. die Zelle umfasst eine erste, als Blechteil ausgestaltete Kontaktfahne, die auf die erste oder auf die zweite Stirnseite aufgeschweißt ist und die einen sich in einer Ebene parallel zu der ersten Stirnseite oder der zweiten erstreckenden planaren Abschnitt aufweist, und
f. die Zelle umfasst eine zweite, als Blechteil ausgestaltete Kontaktfahne, die auf die nicht mit der ersten Kontaktfahne versehene Stirnseite aufgeschweißt ist und die einen sich in einer Ebene parallel zu dieser Stirnseite erstreckenden, planaren Teilabschnitt und einen von dieser Ebene abgewinkelten, sich bis in die Ebene des planaren Abschnitts erstreckenden Teilabschnitt aufweist.

Bevorzugt ist die erste Kontaktfahne auf die erste Stirnseite aufgeschweißt. Die zweite Kontaktfahne ist bevorzugt auf die erste Stirnseite aufgeschweißt. Im Ergebnis umfasst die Zelle also bevorzugt eine erste, als Blechteil ausgestaltete Kontaktfahne, die auf die erste Stirnseite aufgeschweißt ist und die einen sich in einer Ebene parallel zu der ersten Stirnseite erstreckenden planaren Abschnitt aufweist, und eine zweite, als Blechteil ausgestaltete Kontaktfahne, die auf die zweite Stirnseite aufgeschweißt ist und die einen sich in einer Ebene parallel zu der zweiten Stirnseite erstreckenden, planaren Teilabschnitt und einen von dieser Ebene abgewinkelten, sich bis in die Ebene des planaren Abschnitts erstreckenden Teilabschnitt aufweist.

Die Zelle ist bevorzugt nach Art eines geraden Kreiszylinders ausgebildet. Die ebenen Stirnseiten sind also bevorzugt kreisförmig ausgebildet und parallel zueinander ausgerichtet. Durch ihr Zentrum verläuft bevorzugt die Achse des Zylinders, die senkrecht zu den Stirnseiten ausgerichtet ist.

Die Gehäuseteile sind bevorzugt becherförmig ausgebildet. Neben bevorzugt kreisrunden Böden weisen sie bevorzugt jeweils einen hohlzylindrischen Mantel auf. Die Außenseiten der Böden bilden bevorzugt die erwähnten Stirnseiten.

Zwischen den zwei metallischen Gehäuseteilen ist üblicherweise eine ringförmige Dichtung aus Kunststoff angeordnet, welche die Gehäuseteile elektrisch gegeneinander isoliert. Darüber hinaus gewährleistet die Dichtung einen flüssigkeitsdichten Verschluss der Zellen.

Die Gehäuseteile können beispielsweise aus vernickeltem Stahl oder Blech bestehen. Weiterhin kommt als metallischer Werkstoff auch Trimetall in Frage, beispielsweise mit derAbfolge Nickel, Stahl (oder Edelstahl) und Kupfer. Es ist auch denkbar, dass ein Gehäuseteil aus Aluminium oder einer Aluminiumlegierung gebildet ist während das andere aus Stahl oder aus Trimetall besteht.

Bevorzugt sind die Elektroden der Zelle bandförmig ausgebildet und Bestandteil eines Wickel-Verbundkörpers, der in dem Innenraum des Gehäuses angeordnet ist. Dieser ist bevorzugt aus mindestens zwei spiralförmig um eine Wickelachse herum gewickelten Elektrodenbändern (der positiven und der negativen Elektrode) und mindestens einem um die Wickelachse herum spiralförmig gewickelten Separatorband gebildet. Bevorzugt ist der Wickel-Verbundkörper ebenfalls zylindrisch ausgebildet und weist entsprechend bevorzugt gleichfalls zwei kreisförmige Stirnseiten auf.

Die Stirnseiten des Wickel-Verbundkörpers werden bevorzugt von den Längsrändern des mindestens einen Separatorbands gebildet und weisen in Richtung der kreisrunden und zueinander parallelen Gehäuseböden, so dass die Wickelachse senkrecht oder zumindest im Wesentlichen senkrecht zu den Gehäuseböden ausgerichtet ist. Bevorzugt fallen die Wickelachse und die Zylinderachse zusammen.

Beispiele solcher Wickel-Verbundkörper sind beispielsweise in der WO 2010/089152 A1 beschrieben.

In dem Gehäuse der erfindungsgemäßen Zelle liegen die Stirnseiten des Wickel-Verbundkörpers bevorzugt an den Innenseiten der bevorzugt kreisrunden Böden an.

Sowohl die positive Elektrode als auch die negative Elektrode umfassen bevorzugt einen bandförmigen, mit Elektrodenmaterial bedeckten metallischen Stromkollektor. Die Stromkollektoren dienen dazu, das Elektrodenmaterial möglichst großflächig elektrisch zu kontaktieren. Sie bestehen üblicherweise aus bandförmigen, flächigen Metallsubstraten, beispielsweise aus Metallfolien oder aus einem Metallschaum oder aus einem metallisierten Vlies.

Zur elektrischen Kontaktierung der Elektroden an die Gehäuseteile können diese Stromkollektoren unmittelbar an die Gehäuseteile, bevorzugt an die Innenseiten der Böden der Gehäuseteile, geschweißt sein. Alternativ können die Stromkollektoren auch an den erwähnten separaten elektrischen Leiter geschweißt sein, der seinerseits elektrisch mit den Gehäuseteilen verbunden ist.

Als Elektrodenmaterialien kommen für die Elektroden der erfindungsgemäßen Zelle sämtliche Materialien in Frage, die Lithiumionen aufnehmen und wieder abgeben können. Stand der Technik sind diesbezüglich für die negative Elektrode sekundärer Lithium-Ionen-Systeme insbesondere Materialien auf Kohlenstoffbasis wie graphitischer Kohlenstoff oder zur Interkalation von Lithium befähigte nichtgraphitische Kohlenstoffmaterialien. Für die positive Elektrode sekundärer Lithium-Ionen-Systeme kommen etwa Lithium-Metalloxid-Verbindungen und Lithium-Metallphosphat-Verbindungen wie LiCoO₂ und LiFePO₄ in Frage.

Weiterhin können die Elektroden Elektrodenbinder und Leitmittel enthalten. Die Elektrodenbinder gewährleisten die mechanische Stabilität der Elektroden und sorgen für die Kontaktierung der Partikel aus elektrochemisch aktivem Material untereinander sowie zum Stromkollektor. Leitmittel wie Ruß dienen dazu, die elektrische Leitfähigkeit der Elektroden zu erhöhen.

Die Kontaktfahnen der Zelle werden - wie die Kontaktfahnen von aus dem Stand der Technik bekannten Zellen, benötigt, um die Zelle zu fixieren und elektrisch zu verbinden.

Gegenüber dem Stand der Technik zeichnet sich die beanspruchte Zelle durch die speziell ausgestaltete zweite Kontaktfahne aus. Die erfindungsgemäße Zelle weist nämlich zusätzlich das folgende Merkmal g. auf:
g. Der abgewinkelte Teilabschnitt umfasst einen Expansionsabschnitt, in dem die zweite Kontaktfahne dazu ausgebildet ist, bei einer definierten Zugbelastung in ihrer Haupterstreckungsrichtung gezielt und vorhersagbar in die Haupterstreckungsrichtungzu expandieren.

Bei der Zugbelastung erfährt der abgewinkelte Teilabschnitt eine Längenexpansion, die zweite Kontaktfahne wird verlängert und zwar bevorzugt ohne dass sich dabei der Querschnitt der zweiten Kontaktfahne in dem Expansionsabschnitt ändert. Eine solche Zugbelastung kann beispielsweise durch das eingangs beschriebene Auseinandergleiten von Gehäuseteilen einer Zelle gemäß der WO 2012/048995 A1 hervorgerufen werden. Eine Blockade dieses Mechanismus kann durch die erfindungsgemäße Ausgestaltung der zweiten Kontaktfahne ausgeschlossen werden.

Zur Klarstellung: Unter der Haupterstreckungsrichtung der Kontaktfahne ist die Richtung zu verstehen, in der die Kontaktfahne im flach ausgebreiteten Zustand, also vor Abwinkelung des abgewinkelten Teilabschnitts, ihre größte Ausdehnung besitzt. Wenn der abgewinkelte Teilabschnitt in einem Winkel von 90° auf der Ebene des planaren Teilabschnitts der zweiten Kontaktfahne steht, ist die Haupterstreckungsrichtung in dem Expansionsabschnitt exakt parallel zur Achse der zylindrischen Zelle.

Grundsätzlich ist es möglich, dass der abgewinkelte Teilabschnitt den Expansionsabschnitt nicht nur umfasst, sondern vielmehr selbst als der Expansionsabschnitt ausgebildet ist. Besonders bevorzugt umfasst der abgewinkelte Teilabschnitt allerdings einen endständigen Kontaktabschnitt und zwischen dem Kontaktabschnitt und der Ebene des planaren Teilabschnitts den Expansionsabschnitt.

In einer besonders bevorzugten Ausführungsform zeichnet sich die Zelle zusätzlich durch mindestens eines der unmittelbar folgenden zusätzlichen Merkmale a. bis d. aus:
a. Die zweite Kontaktfahne ist in dem Expansionsabschnitt als bahn- oder streifenförmiger Leiter oder als Leiter mit rundem Querschnitt ausgebildet oder umfasst in dem Expansionsabschnitt mindestens einen solchen Leiter.
b. Die zweite Kontaktfahne weist in dem Expansionsabschnitt in der Haupterstreckungsrichtung einen gegenüber dem endständigen Kontaktabschnitt und/oder dem Teilabschnitt verjüngten Querschnitt auf.
c. Die zweite Kontaktfahne oder der mindestens eine bahn- oder streifenförmige Leiter oder Leiter mit rundem Querschnitt weist in dem Expansionsabschnitt einen nicht linearen, insbesondere einen gebogenen Verlauf auf.
d. Die Länge der zweiten Kontaktfahne in dem Expansionsabschnitt und/oder die Länge des mindestens einen bahn- oder streifenförmigen Leiters oder Leiters mit rundem Querschnitt überschreitet die Höhe der Zelle mindestens um den Faktor 1,1, vorzugsweise um den Faktor 1,3.

Bevorzugt sind zumindest die unmittelbar vorstehenden Merkmale a. und c., vorzugsweise sogar die Merkmale unmittelbar vorstehenden a., c und d., besonders bevorzugt die unmittelbar vorstehenden Merkmale a. bis d., in Kombination miteinander realisiert.

Wenn die Kontaktfahne in dem Expansionsabschnitt als bahn- oder streifenförmiger Leiter ausgebildet ist oder einen solchen Leiter umfasst, so weist dieser Leiterbevorzugt eine Breite im Bereich von 0,5 mm bis 4 mm auf. Bevorzugt ist die Breite des bahn- oder streifenförmigen Leiters in dem Expansionsabschnitt konstant.

Durch die Verjüngung kann die Kontaktfahne in dem Expansionsabschnitt auch die Funktion einer Schmelzsicherung haben. Fließt ein zu hoher Strom durch eine entsprechend verjüngte Kontaktfahne, so kann die Kontaktfahne durch Schmelzen zerstört werden. Zumindest kommt es in solchen Fällen aber zu einer Verfärbung der Kontaktfahne im Bereich der Verjüngung, die als Indikator eines Kurzschlusses dienen kann.

Ein nicht linearer Verlauf der zweiten Kontaktfahne in dem Expansionsabschnitt bedeutet, dass die Kontaktfahne in diesem Abschnitt mindestens einem Richtungswechsel, vorzugsweise zwei oder mehr Richtungswechseln, unterliegt.

Unter der Höhe der Zelle versteht man gemeinhin und auch vorliegend den Abstand zwischen der ersten und der zweiten Stirnseite des Gehäuses. Besonders bevorzugt überschreitet die Länge der zweiten Kontaktfahne und/oder die Länge des mindestens einen bahn- oder streifenförmigen Leiters oder Leiters mit rundem Querschnitt in dem Expansionsabschnitt die Höhe der Zelle mindestens um einen Faktor im Bereich von 1,1 bis 5, insbesondere im Bereich von 1,3 bis 5.

In einer weiteren besonders bevorzugten Ausführungsform zeichnet sich die Zelle zusätzlich durch mindestens eines der unmittelbar folgenden zusätzlichen Merkmale a. bis c. aus:
a. Die Kontaktfahne umfasst in dem Expansionsabschnitt mindestens einen gebogenen oder abgeknickten Unterabschnitt.
b. Die Kontaktfahne ist in dem Expansionsabschnitt S-, U- oder Z-förmig ausgebildet oder umfasst innerhalb des Expansionsabschnitts einen derart ausgebildeten Unterabschnitt.
c. Die Kontaktfahne ist in dem Expansionsabschnitt wellenförmig ausgebildet oder umfasst innerhalb des Expansionsabschnitts einen derart ausgebildeten Unterabschnitt.

Bevorzugt sind zumindest die unmittelbar vorstehenden Merkmale a. und b., vorzugsweise sogar die unmittelbar vorstehenden Merkmale a. bis c., in Kombination miteinander realisiert. Besonders bevorzugt ist die zweite Kontaktfahne in all diesen Fällen in dem Expansionsabschnitt als bahn- oder streifenförmiger Leiter oder als Leiter mit rundem Querschnitt ausgebildet und weist in dem Expansionsabschnitt eine Länge auf, die die Höhe der Zelle mindestens um den Faktor 1,1 überschreitet. Wenn die Kontaktfahne ist in dem Expansionsabschnitt wellenförmig ausgebildet ist oder einen wellenförmig ausgebildeten Unterabschnitt umfasst, so handelt es sich bei der Wellenform bevorzugt um eine sinus-, sägezahn-, dreieck- oder rechteckförmige Welle.

In einer weiteren besonders bevorzugten Ausführungsform zeichnet sich die Zelle zusätzlich durch mindestens eines der unmittelbar folgenden zusätzlichen Merkmale a. bis d. aus:
a. Der Expansionsabschnitt umfasst zwei Leiterbahnen oder zwei streifenförmige Leiter oder zwei Leiter mit rundem Querschnitt.
b. Die zwei Leiterbahnen oder die zwei streifenförmigen Leiter oder die zwei Leiter mit rundem Querschnitt weisen in dem Expansionsabschnitt jeweils einen gebogenen Verlauf auf.
c. In dem Expansionsabschnitt sind die zwei Leiterbahnen oder die zwei streifenförmigen Leiter oder die zwei Leiter mit rundem Querschnitt in gegenläufigen Biegerichtungen gebogen.
d. Die zweite Kontaktfahne ist in dem Expansionsabschnitt O-förmig ausgebildet oder umfasst innerhalb des Expansionsabschnitts einen derart ausgebildeten Unterabschnitt.

Bevorzugt sind zumindest die unmittelbar vorstehenden Merkmale a. und b., vorzugsweise sogar die unmittelbar vorstehenden Merkmale a. bis c., besonders bevorzugt sogar die unmittelbar vorstehenden Merkmale a. bis d., in Kombination miteinander realisiert.

In einer weiteren besonders bevorzugten Ausführungsform zeichnet sich die Zelle zusätzlich durch mindestens eines der unmittelbar folgenden zusätzlichen Merkmale a. und b. aus:
a. Die erste Kontaktfahne umfasst einen Kontaktabschnitt, der aus der Ebene des planaren Abschnitts abwinkelbar oder abgewinkelt ist.
b. Der Kontaktabschnitt der ersten Kontaktfahne weist in die gleiche Richtung wie der Kontaktabschnitt der zweiten Kontaktfahne.

Bevorzugt sind die unmittelbar vorstehenden Merkmale a. und b. in Kombination miteinander realisiert.

In einer weiteren besonders bevorzugten Ausführungsform zeichnet sich die Zelle zusätzlich durch mindestens eines der unmittelbar folgenden zusätzlichen Merkmale a. bis c. aus:
a. Die Zelle weist einen Durchmesser im Bereich von 5 mm bis 50 mm, bevorzugt von 5 mm bis 25 mm, auf.
b. Die Zelle weist eine Höhe im Bereich von 3 mm bis 50 mm auf.
c. Die Zelle ist eine Knopfzelle.

Bevorzugt sind zumindest die unmittelbar vorstehenden Merkmale a. und b., vorzugsweise sogar die unmittelbar vorstehenden Merkmale a. bis c., in Kombination miteinander realisiert.

In einer weiteren besonders bevorzugten Ausführungsform zeichnet sich die Zelle zusätzlich durch mindestens eines der unmittelbar folgenden zusätzlichen Merkmale a. und b. aus:
a. Die Kontaktfahnen bestehen aus Metallblech mit einer Dicke im Bereich von 0,25 mm bis 2,5 mm.
b. Die Kontaktfahnen sind als Stanzteile gefertigt.

Bevorzugt sind die unmittelbar vorstehenden Merkmale a. und b. in Kombination miteinander realisiert.

In einer weiteren besonders bevorzugten Ausführungsform zeichnet sich die Zelle zusätzlich durch mindestens eines der unmittelbar folgenden zusätzlichen Merkmale a. und b. aus:
a. Die Zelle weist ein Berstkreuz auf.
b. Das Berstkreuz ist in die erste Stirnseite oder in die zweite Stirnseite eingebracht.

Bevorzugt sind die unmittelbar vorstehenden Merkmale a. und b. in Kombination miteinander realisiert.

In einer weiteren besonders bevorzugten Ausführungsform zeichnet sich die Zelle zusätzlich durch mindestens eines der unmittelbar folgenden zusätzlichen Merkmale a. und b. aus:
a. Das Gehäuse besteht aus zwei axial gegeneinander verschiebbaren Gehäuseteilen.
b. Das Gehäuse weist im Mantel ein Loch auf, das zur Entlüftung des Innenraums dienen kann.

Bevorzugt sind die unmittelbar vorstehenden Merkmale a. und b. in Kombination miteinander realisiert.

In einer weiteren besonders bevorzugten Ausführungsform zeichnet sich die Zelle zusätzlich durch das unmittelbar folgende zusätzliche Merkmal a. aus:
a. Die Zelle ist über die Kontaktabschnitte und auf einer Platine fixiert.

Weitere Merkmale, Einzelheiten und Vorzüge der Erfindung ergeben sich aus den Ansprüchen und der Zusammenfassung, deren beider Wortlaut durch Bezugnahme zum Inhalt der Beschreibung gemacht wird, der folgenden Beschreibung bevorzugter Ausführungsformen der Erfindung sowie anhand der Zeichnungen. Hierbei zeigen schematisch:
- Fig. 1: Eine erste Ausführungsform einer erfindungsgemäßen Zelle mit einer S-förmigen zweiten Kontaktfahne,
- Fig. 2: eine zweite Ausführungsform einer erfindungsgemäßen Zelle mit einer O-förmigen zweiten Kontaktfahne, und
- Fig. 3: eine dritte Ausführungsform einer erfindungsgemäßen Zelle mit einer wellenförmigen zweiten Kontaktfahne.

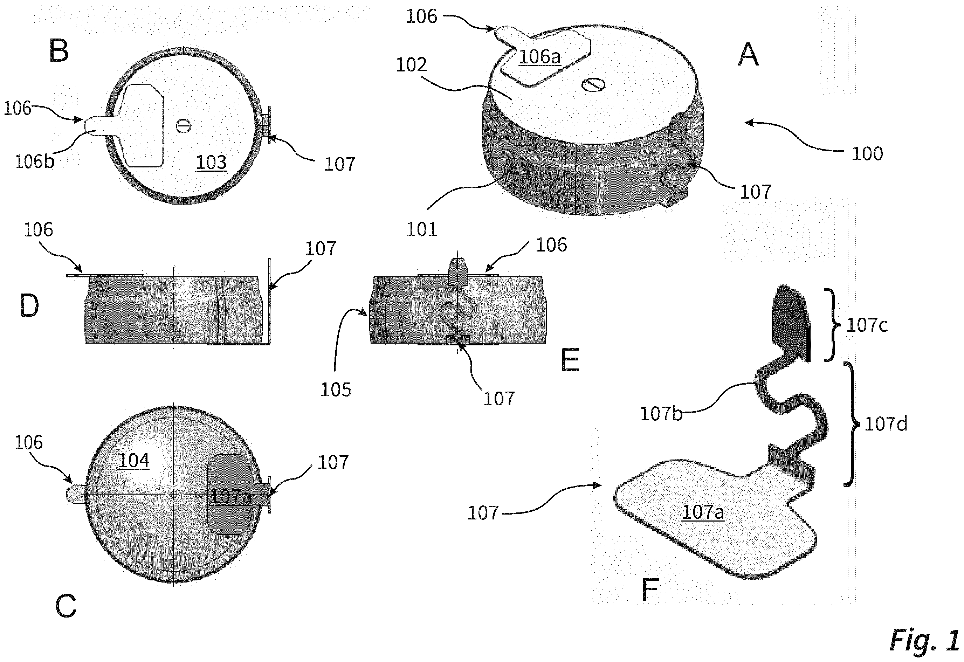

Die in Fig. 1 dargestellte Zelle 100 weist ein zylindrisches Gehäuse auf, das aus den Gehäuseteilen 101 und 102 zusammengesetzt ist. Es handelt sich bei der Zelle 100 um eine Knopfzelle. Das erste Gehäuseteil 101 bildet den positiven Pol der Zelle 100, das zweite Gehäuseteil 102 den negativen Pol. An seinen axialen Enden umfasst das Gehäuse die ebene erste Stirnseite 103 und die ebene zweite Stirnseite 104. Diese sind über den ringförmigen Mantel 105 miteinander verbunden.

Bei der Zelle 100 handelt es sich um eine Lithium-lonen-Zelle. In dem Gehäuse ist ein Elektroden-Separator-Wickel (nicht dargestellt) ähnlich den in der WO 2010/089152 A1 beschriebenen angeordnet.

Die Zelle 100 umfasst die als Blechteil ausgestaltete erste Kontaktfahne 106, die auf die erste Stirnseite 103 aufgeschweißt ist. Die Kontaktfahne 106 weist den sich in einer Ebene parallel zu der ersten Stirnseite 103 erstreckenden, planaren Abschnitt 106a sowie den aus der Ebene des Abschnitts 106a abwinkelbaren Kontaktabschnitt 106b auf.

Weiterhin umfasst die Zelle 100 die als Blechteil ausgestaltete zweite Kontaktfahne 107, die auf die zweite Stirnseite 104 aufgeschweißt ist, auf. Die Kontaktfahne 107 umfasst den sich in einer Ebene parallel zu der zweiten Stirnseite 104 erstreckenden, planaren Teilabschnitt 107a und den von dieser Ebene abgewinkelten, sich bis in die Ebene des planaren Abschnitts 106a erstreckenden Teilabschnitt 107b. Dieser abgewinkelte Teilabschnitt 107b umfasst den endständigen Kontaktabschnitt 107c und zwischen dem Kontaktabschnitt 107c und der Ebene des planaren Teilabschnitts 107a den Expansionsabschnitt 107d. Aus diesem heraus kann die zweite Kontaktfahne 107 bei Zugbelastung in ihrer Haupterstreckungsrichtung entspannen.

Die zweite Kontaktfahne 107 ist in dem Expansionsabschnitt 107d S-förmig, insbesondere als bahnförmiger Leiter in S-Form oder als streifenförmigen Leiter in S-Form oder als Leiter mit rundem Querschnitt in S-Form ausgebildet, weist also in dem Expansionsabschnitt 107d einen nicht linearen Verlauf auf. Die Gesamtlänge des S-förmig ausgebildeten Leiters überschreitet die Höhe der Zelle signifikant.

Fig. 1 umfasst mehrere separate Darstellungen der Zelle 100. In Darstellung A ist die Zelle in einer Draufsicht schräg von vorne, in der Darstellung B senkrecht von oben, in der Darstellung C senkrecht von unten und in den Darstellungen D und E jeweils von der Seite abgebildet.

Darstellung F zeigt die zweite Kontaktfahne 107, bevor sie an die Zelle 100 angeschweißt wurde. Der planare Teilabschnitt 107a ist hell dargestellt, der abgewinkelte Teilabschnitt 107b, der sich in den Kontaktabschnitt 107c und den Expansionsabschnitt 107d unterteilt, dunkel.

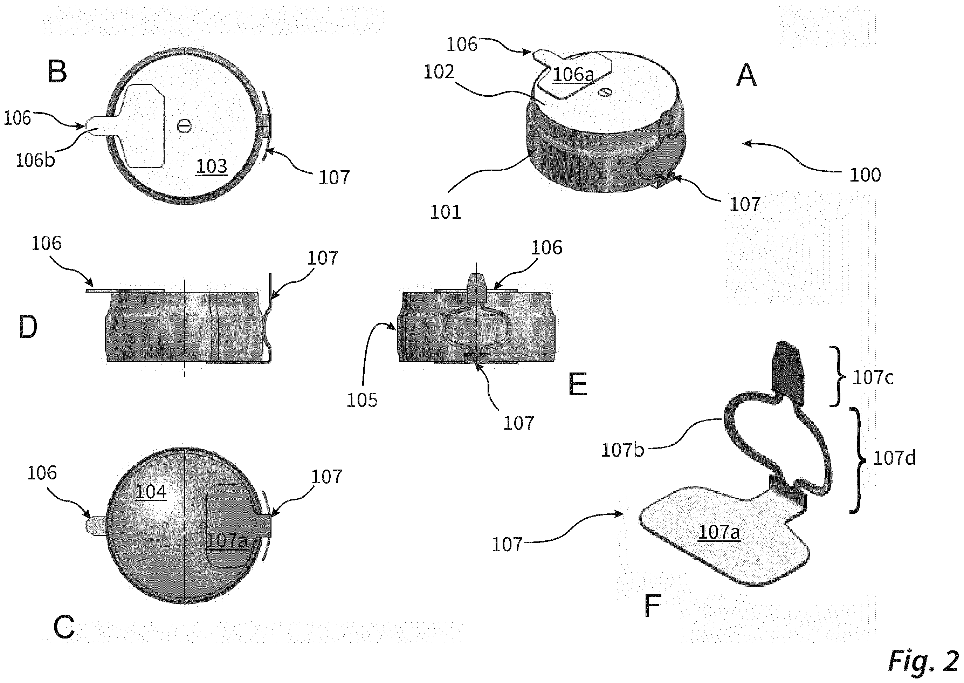

Auch Fig. 2 umfasst mehrere separate Darstellungen der Zelle 100. Wie in Fig. 1 ist in Darstellung A die Zelle in einer Draufsicht schräg von vorne, in der Darstellung B senkrecht von oben, in der Darstellung C senkrecht von unten und in den Darstellungen D und E jeweils von der Seite abgebildet.

Darstellung F zeigt auch hier die zweite Kontaktfahne 107, bevor sie an die Zelle 100 angeschweißt wurde. Der planare Teilabschnitt 107a ist hell dargestellt, der abgewinkelte Teilabschnitt 107b, der sich in den Kontaktabschnitt 107c und den Expansionsabschnitt 107d unterteilt, dunkel.

Die in Fig. 2 dargestellte Ausführungsform der Zelle 100 unterscheidet sich von der in Fig. 1 dargestellten lediglich in der Ausgestaltung der zweiten Kontaktfahne. Diese ist nicht S-förmig sondern O-förmig ausgebildet.

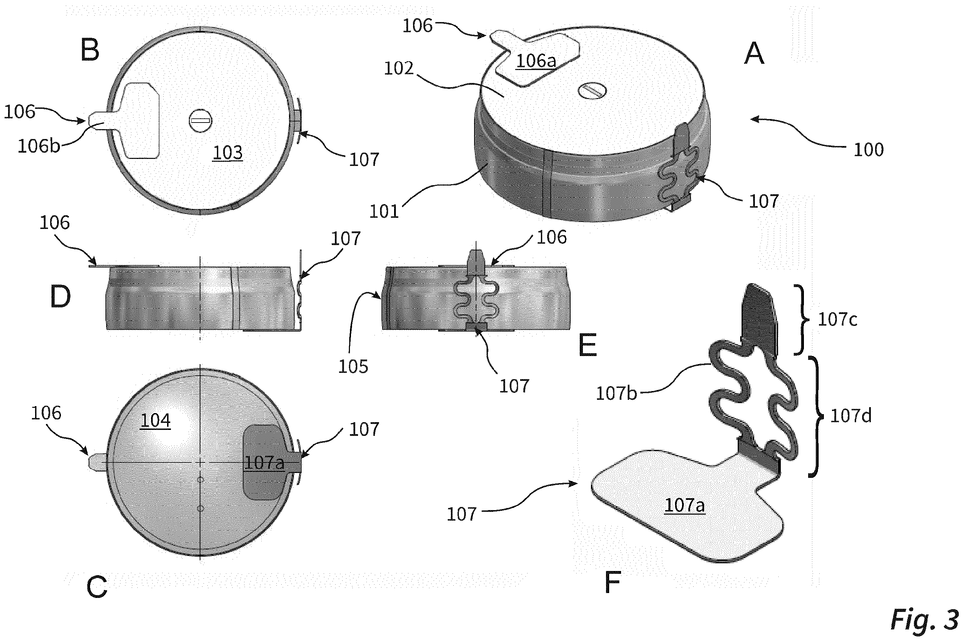

Auch Fig. 3 umfasst mehrere separate Darstellungen der Zelle 100. Wie in Fig. 1 und Fig. 2 ist in Darstellung A die Zelle in einer Draufsicht schräg von vorne, in der Darstellung B senkrecht von oben, in der Darstellung C senkrecht von unten und in den Darstellungen D und E jeweils von der Seite abgebildet.

Darstellung F zeigt auch hier die zweite Kontaktfahne 107, bevor sie an die Zelle 100 angeschweißt wurde. Der planare Teilabschnitt 107a ist hell dargestellt, der abgewinkelte Teilabschnitt 107b, der sich in den Kontaktabschnitt 107c und den Expansionsabschnitt 107d unterteilt, dunkel.

Die in Fig. 3 dargestellte Ausführungsform der Zelle 100 unterscheidet sich von der in Fig. 1 dargestellten lediglich in der Ausgestaltung der zweiten Kontaktfahne. Diese ist nicht S-förmig sondern wellenförmig ausgebildet.

## Patentansprüche

1. Zylindrische Zelle (100) mit den Merkmalen
a. Die Zelle umfasst ein einen Innenraum einschließendes, aus einem ersten und einem zweiten metallischen Gehäuseteil (101, 102) zusammengesetztes, zylindrisches Gehäuse,
b. das Gehäuse umfasst an seinen axialen Enden eine erste ebene Stirnseite (103) und eine zweite ebene Stirnseite (104), die über einen ringförmigen Mantel (105) miteinander verbunden sind,
c. die Zelle umfasst eine positive Elektrode und eine negative Elektrode, von denen mindestens eine Lithiumionen interkalieren und/oder deinterkalieren kann,
d. die positive Elektrode ist unmittelbar oder über einen separaten elektrischen Leiter elektrisch mit dem ersten Gehäuseteil (101) und die negative Elektrode ist unmittelbar oder über einen separaten elektrischen Leiter elektrisch mit dem zweiten Gehäuseteil (102) verbunden,
e. die Zelle umfasst eine erste, als Blechteil ausgestaltete Kontaktfahne (106), die auf die erste Stirnseite (103) aufgeschweißt ist und die einen sich in einer Ebene parallel zu der ersten Stirnseite (103) erstreckenden, planaren Abschnitt (106a) aufweist, und
f. die Zelle umfasst eine zweite, als Blechteil ausgestaltete Kontaktfahne (107), die auf die zweite Stirnseite (104) aufgeschweißt ist und die einen sich in einer Ebene parallel zu der zweiten Stirnseite (104) erstreckenden, planaren Teilabschnitt (107a) und einen von dieser Ebene abgewinkelten, sich bis in die Ebene des planaren Abschnitts (106a) erstreckenden Teilabschnitt (107b) aufweist,
wobei
g. der abgewinkelte Teilabschnitt (107b) einen Expansionsabschnitt (107d) umfasst, in dem die zweite Kontaktfahne (107) dazu ausgebildet ist, bei einer definierten Zugbelastung in ihrer Haupterstreckungsrichtung gezielt und vorhersagbar in die Haupterstreckungsrichtung zu expandieren.

2. Zelle nach Anspruch 1 mit dem folgenden zusätzlichen Merkmal:
a. Der abgewinkelte Teilabschnitt (107b) umfasst einen endständigen Kontaktabschnitt (107c) und zwischen dem Kontaktabschnitt (107c) und der Ebene des planaren Teilabschnitts (107a) den Expansionsabschnitt (107d).

3. Zelle nach Anspruch 1 oder nach Anspruch 2 mit mindestens einem der folgenden zusätzlichen Merkmale:
a. Die zweite Kontaktfahne (107) ist in dem Expansionsabschnitt (107d) als bahn- oder streifenförmiger Leiter oder Leiter mit rundem Querschnitt ausgebildet oder umfasst in dem Expansionsabschnitt (107d) mindestens einen solchen Leiter.
b. Die zweite Kontaktfahne (107) weist in dem Expansionsabschnitt (107d) in der Haupterstreckungsrichtung einen gegenüber dem endständigen Kontaktabschnitt (107c) des abgewinkelten Teilabschnitts (107b) und/oder dem planaren Teilabschnitt (107a) verjüngten Querschnitt auf.
c. Die zweite Kontaktfahne (107) oder der mindestens eine bahn- oder streifenförmige Leiter oder Leiter mit rundem Querschnitt weist in dem Expansionsabschnitt (107d) einen nicht linearen, insbesondere einen gebogenen Verlauf auf.
d. Die Länge der zweiten Kontaktfahne (107) in dem Expansionsabschnitt (107d) und/oder die Länge des mindestens einen bahn- oder streifenförmigen Leiters oder Leiters mit rundem Querschnitt überschreitet die Höhe der Zelle (100) mindestens um den Faktor 1,1.

4. Zelle nach einem der Ansprüche 1 bis 3 mit mindestens einem der folgenden zusätzlichen Merkmale:
a. Die Kontaktfahne (107) umfasst in dem Expansionsabschnitt (107d) mindestens einen gebogenen oder abgeknickten Unterabschnitt.
b. Die Kontaktfahne (107) ist in dem Expansionsabschnitt (107d) S-, U- oder Z-förmig ausgebildet oder umfasst innerhalb des Expansionsabschnitts (107d) einen derart ausgebildeten Unterabschnitt.
c. Die Kontaktfahne (107) ist in dem Expansionsabschnitt (107d) wellenförmig ausgebildet oder umfasst innerhalb des Expansionsabschnitts (107d) einen derart ausgebildeten Unterabschnitt.

5. Zelle nach einem der vorhergehenden Ansprüche mit mindestens einem der folgenden zusätzlichen Merkmale:
a. Der Expansionsabschnitt (107d) umfasst zwei Leiterbahnen oder zwei streifenförmigen Leiter oder zwei Leiter mit rundem Querschnitt.
b. Die zwei Leiterbahnen oder die zwei streifenförmigen Leiter oder die zwei Leiter mit rundem Querschnitt weisen in dem Expansionsabschnitt (107d) jeweils einen gebogenen Verlauf auf.
c. In dem Expansionsabschnitt (107d) sind die zwei Leiterbahnen oder die zwei streifenförmigen Leiter oder die zwei Leiter mit rundem Querschnitt in gegenläufigen Biegerichtungen gebogen.
d. Die zweite Kontaktfahne (107) ist in dem Expansionsabschnitt O-förmig ausgebildet oder umfasst innerhalb des Expansionsabschnitts (107d) einen derart ausgebildeten Unterabschnitt.

6. Zelle nach einem der vorhergehenden Ansprüche mit mindestens einem der folgenden zusätzlichen Merkmale:
a. Die erste Kontaktfahne (106) umfasst einen Kontaktabschnitt (106b), der aus der Ebene des Abschnitts (106a) abwinkelbar oder abgewinkelt ist.
b. Der Kontaktabschnitt (106b) der ersten Kontaktfahne weist in die gleiche Richtung wie der Kontaktabschnitt (107c) der zweiten Kontaktfahne (107).

7. Zelle nach einem der vorhergehenden Ansprüche mit mindestens einem der folgenden zusätzlichen Merkmale:
a. Die Zelle (100) weist einen Durchmesser im Bereich von 5 mm bis 25 mm auf.
b. Die Zelle (100) weist eine Höhe im Bereich von 3 mm bis 50 mm auf.
c. Die Zelle (100) ist eine Knopfzelle.

8. Zelle nach einem der vorhergehenden Ansprüche mit mindestens einem der folgenden zusätzlichen Merkmale:
a. Die Kontaktfahnen (106) und (107) bestehen aus Metallblech mit einer Dicke im Bereich von 0,25 mm bis 2,5 mm.
b. Die Kontaktfahnen (106) und (107) sind als Stanzteile gefertigt.

9. Zelle nach einem der vorhergehenden Ansprüche mit mindestens einem der folgenden zusätzlichen Merkmale:
a. Die Zelle weist ein Berstkreuz auf.
b. Das Berstkreuz ist in die erste Stirnseite (103) oder in die zweite Stirnseite (104) eingebracht.

10. Zelle nach einem der vorhergehenden Ansprüche mit mindestens einem der folgenden zusätzlichen Merkmale:
a. Das Gehäuse besteht aus zwei axial gegeneinander verschiebbaren Gehäuseteilen.
b. Das Gehäuse weist im Mantel ein Loch auf, das zur Entlüftung des Innenraums dienen kann.

11. Zelle nach einem der vorhergehenden Ansprüche mit dem folgenden zusätzlichen Merkmal:
a. Die Zelle ist über die Kontaktabschnitte (106b) und (107c) auf einer Platine fixiert.

## Claims

1. Cylindrical cell (100) having the features
a. The cell comprises a cylindrical housing which encloses an interior space and which is composed of a first and a second metal housing part (101, 102),
b. the housing comprises, at its axial ends, a first planar end face (103) and a second planar end face (104) which are connected to one another by means of an annular casing (105),
c. the cell comprises a positive electrode and a negative electrode, at least one of which can intercalate and/or deintercalate lithium ions,
d. the positive electrode is electrically connected to the first housing part (101) directly or via a separate electrical conductor, and the negative electrode is electrically connected to the second housing part (102) directly or via a separate electrical conductor,
e. the cell comprises a first contact lug (106) which is configured as a sheet-metal part, which is welded onto the first end face (103) and which has a planar section (106a) that extends in a plane parallel to the first end face (103), and
f. the cell comprises a second contact lug (107) which is configured as a sheet-metal part, which is welded onto the second end face (104) and which has a planar subsection (107a) that extends in a plane parallel to the second end face (104) and which has a subsection (107b) that is angled away from the said plane and extends as far as into the plane of the planar section (106a),
wherein
g. the angled-away subsection (107b) comprises an expansion section (107d) in which the second contact lug (107) is designed to expand in the main direction of extent in a targeted and predictable manner under a defined tensile loading in its main direction of extent.

2. Cell according to Claim 1 having the following additional feature:
a. The angled-away subsection (107b) comprises a terminal contact section (107c) and the expansion section (107d) between the contact section (107c) and the plane of the planar subsection (107a).

3. Cell according to Claim 1 or according to Claim 2 having at least one of the following additional features:
a. The second contact lug (107) is designed as a track- or strip-like conductor or conductor with a round cross section in the expansion section (107d) or comprises at least one conductor of this kind in the expansion section (107d) .
b. The second contact lug (107) has, in the main direction of extent, a cross section which is tapered in relation to the terminal contact section (107c) of the angled-away subsection (107b) and/or the planar subsection (107a) in the expansion section (107d).
c. The second contact lug (107) or the at least one track- or strip-like conductor or conductor with a round cross section has a non-linear, in particular a bent, profile in the expansion section (107d).
d. The length of the second contact lug (107) in the expansion section (107d) and/or the length of the at least one track- or strip-like conductor or conductor with a round cross section exceeds the height of the cell (100) at least by the factor 1.1.

4. Cell according to one of Claims 1 to 3 having at least one of the following additional features:
a. The contact lug (107) comprises at least one bent or bent-away lower section in the expansion section (107d) .
b. The contact lug (107) is of S-, U- or Z-shaped design in the expansion section (107d) or comprises a lower section which is designed in this way within the expansion section (107d).
c. The contact lug (107) is of wave-like design in the expansion section (107d) or comprises a lower section which is designed in this way within the expansion section (107d).

5. Cell according to one of the preceding claims having at least one of the following additional features:
a. The expansion section (107d) comprises two conductor tracks or two strip-like conductors or two conductors with a round cross section.
b. The two conductor tracks or the two strip-like conductors or the two conductors with a round cross section each have a bent profile in the expansion section (107d) .
c. The two conductor tracks or the two strip-like conductors or the two conductors with a round cross section are bent in opposite bending directions in the expansion section (107d).
d. The second contact lug (107) is of O-shaped design in the expansion section or comprises a lower section which is designed in this way within the expansion section (107d).

6. Cell according to one of the preceding claims having at least one of the following additional features:
a. The first contact lug (106) comprises a contact section (106b) which can be angled away or is angled away from the plane of the section (106a).
b. The contact section (106b) of the first contact lug points in the same direction as the contact section (107c) of the second contact lug (107).

7. Cell according to one of the preceding claims having at least one of the following additional features:
a. The cell (100) has a diameter in the range of from 5 mm to 25 mm.
b. The cell (100) has a height in the range of from 3 mm to 50 mm.
c. The cell (100) is a button cell.

8. Cell according to one of the preceding claims having at least one of the following additional features:
a. The contact lugs (106) and (107) consist of sheet metal with a thickness in the range of from 0.25 mm to 2.5 mm.
b. The contact lugs (106) and (107) are manufactured as stamped parts.

9. Cell according to one of the preceding claims having at least one of the following additional features:
a. The cell has a rupture cross.
b. The rupture cross is made in the first end face (103) or in the second end face (104).

10. Cell according to one of the preceding claims having at least one of the following additional features:
a. The housing consists of two housing parts which can be displaced axially in relation to one another.
b. The housing has, in the casing, a hole which can serve to vent the interior space.

11. Cell according to one of the preceding claims having the following additional feature:
a. The cell is fixed on a printed circuit board via the contact sections (106b) and (107c).

## Revendications

1. Cellule cylindrique (100) présentant les caractéristiques suivantes
a. la cellule comporte un boîtier cylindrique renfermant un espace intérieur et constitué d'une première et d'une deuxième partie de boîtier métallique (101, 102),
b. le boîtier comporte, à ses extrémités axiales, un premier côté frontal plan (103) et un deuxième côté frontal plan (104) qui sont reliés l'un à l'autre par le biais d'une enveloppe annulaire (105),
c. la cellule comporte une électrode positive et une électrode négative, parmi lesquelles au moins l'une peut intercaler et/ou désintercaler des ions de lithium,
d. l'électrode positive est connectée électriquement à la première partie de boîtier (101) directement ou par le biais d'un conducteur électrique séparé et l'électrode négative est connectée électriquement à la deuxième partie de boîtier (102) directement ou par le biais d'un conducteur électrique séparé,
e. la cellule comporte une première languette de contact (106) qui est configurée en tant que pièce en tôle, qui est soudée sur le premier côté frontal (103) et qui comprend une section plane (106a) s'étendant dans un plan parallèlement au premier côté frontal (103), et
f. la cellule comporte une deuxième languette de contact (107) qui est configurée en tant que pièce en tôle, qui est soudée sur le deuxième côté frontal (104) et qui comprend une section partielle plane (107a) s'étendant dans un plan parallèlement au deuxième côté frontal (104) et une section partielle (107b) coudée à partir de ce plan et s'étendant jusque dans le plan de la section plane (106a),
dans laquelle
g. la section partielle coudée (107b) comporte une section d'expansion (107d) dans laquelle la deuxième languette de contact (107) est réalisée pour subir une expansion de manière ciblée et prévisible dans la direction d'étendue principale en cas de contrainte de traction définie dans sa direction d'étendue principale.

2. Cellule selon la revendication 1, présentant la caractéristique supplémentaire suivante :
a. la section partielle coudée (107b) comporte une section de contact terminale (107c) et la section d'expansion (107d) entre la section de contact (107c) et le plan de la section partielle plane (107a).

3. Cellule selon la revendication 1 ou la revendication 2, présentant au moins l'une des caractéristiques supplémentaires suivantes :
a. la deuxième languette de contact (107) est réalisée en tant que conducteur en forme de piste ou de bande ou en tant que conducteur de section transversale circulaire dans la section d'expansion (107d) ou comporte au moins un tel conducteur dans la section d'expansion (107d),
b. la deuxième languette de contact (107) présente, dans la section d'expansion (107d), une section transversale s'amincissant par rapport à la section de contact terminale (107c) de la section partielle coudée (107b) et/ou à la section partielle plane (107a) dans la direction d'étendue principale,
c. la deuxième languette de contact (107) ou l'au moins un conducteur en forme de piste ou de bande ou le conducteur de section transversale circulaire présente une allure non linéaire, en particulier une allure incurvée, dans la section d'expansion (107d),
d. la longueur de la deuxième languette de contact (107) dans la section d'expansion (107d) et/ou la longueur de l'au moins un conducteur en forme de piste ou de bande ou du conducteur de section transversale circulaire dépasse la hauteur de la cellule (100) d'au moins un facteur 1,1.

4. Cellule selon l'une des revendications 1 à 3, présentant au moins l'une des caractéristiques supplémentaires suivantes :
a. la languette de contact (107) comporte, dans la section d'expansion (107d), au moins une sous-section courbée ou coudée,
b. la languette de contact (107) est réalisée en forme de S, de U ou de Z dans la section d'expansion (107d) ou comporte une sous-section réalisée de la sorte à l'intérieur de la section d'expansion (107d),
c. la languette de contact (107) est réalisée de manière ondulée dans la section d'expansion (107d) ou comporte une sous-section réalisée de la sorte à l'intérieur de la section d'expansion (107d).

5. Cellule selon l'une des revendications précédentes, présentant au moins l'une des caractéristiques supplémentaires suivantes :
a. la section d'expansion (107d) comporte deux pistes conductrices ou deux conducteurs en forme de bandes ou deux conducteurs de section transversale circulaire,
b. les deux pistes conductrices ou les deux conducteurs en forme de bandes ou les deux conducteurs de section transversale circulaire présentent respectivement une allure incurvée dans la section d'expansion (107d),
c. dans la section d'expansion (107d), les deux pistes conductrices ou les deux conducteurs en forme de bandes ou les deux conducteurs de section transversale circulaire sont courbés dans des sens de flexion opposés,
d. la deuxième languette de contact (107) est réalisée en forme de O dans la section d'expansion ou comporte une sous-section réalisée de la sorte à l'intérieur de la section d'expansion (107d).

6. Cellule selon l'une des revendications précédentes, présentant au moins l'une des caractéristiques supplémentaires suivantes :
a. la première languette de contact (106) comporte une section de contact (106b) qui peut être coudée ou est coudée hors du plan de la section (106a),
b. la section de contact (106b) de la première languette de contact est orientée dans le même sens que la section de contact (107c) de la deuxième languette de contact (107).

7. Cellule selon l'une des revendications précédentes, présentant au moins l'une des caractéristiques supplémentaires suivantes :
a. la cellule (100) présente un diamètre dans la plage de 5 mm à 25 mm,
b. la cellule (100) présente une hauteur dans la plage de 3 mm à 50 mm,
c. la cellule (100) est une cellule bouton.

8. Cellule selon l'une des revendications précédentes, présentant au moins l'une des caractéristiques supplémentaires suivantes :
a. les languettes de contact (106) et (107) sont constituées de tôle métallique présentant une épaisseur dans la plage de 0,25 mm à 2,5 mm,
b. les languettes de contact (106) et (107) sont fabriquées à partir de pièces découpées.

9. Cellule selon l'une des revendications précédentes, présentant au moins l'une des caractéristiques supplémentaires suivantes :
a. la cellule comprend une croix d'éclatement,
b. la croix d'éclatement est ménagée dans le premier côté frontal (103) ou dans le deuxième côté frontal (104).

10. Cellule selon l'une des revendications précédentes, comprenant au moins l'une des caractéristiques supplémentaires suivantes :
a. le boîtier est constitué de deux parties de boîtier déplaçables axialement l'une par rapport à l'autre,
b. le boîtier comprend, dans l'enveloppe, un trou qui peut servir à la ventilation de l'espace intérieur.

11. Cellule selon l'une des revendications précédentes, présentant la caractéristique supplémentaire suivante :
a. la cellule est fixée sur une carte de circuits imprimés par le biais des sections de contact (106b) et (107c).
